# EUROPEAN PATENT SPECIFICATION

(11) **EP 3 068 201 B1**
(45) Date of publication and mention of the grant of the patent: **07.03.2018**
(21) Application number: 15382101.2
(22) Date of filing: 09.03.2015
(51) Int. Cl.: H05K 7/14

(54) **HOUSING MODULE FOR USE IN A RACK CABINET**
GEHÄUSEMODUL ZUR VERWENDUNG IN EINEM GESTELLSCHRANK
MODULE DE LOGEMENT DESTINÉ À ÊTRE UTILISÉ DANS UNE BAIE

(43) Date of publication of application: 14.09.2016
(73) Proprietor: Angel Iglesias, S.A., 20009 San Sebastián (Guipúzcoa) (ES)
(72) Inventor: García Fidalgo, Roberto, 20009 San Sebastián (Guipúzcoa) (ES); Varona Chozas, César, 20009 San Sebastián (Guipúzcoa) (ES)
(74) Representative: Carpintero Lopez, Francisco

(56) References cited:
- US-A1- 2011 073 726
- US-A1- 2011 180 316
- US-B1- 6 181 549

## Description

### Technical Field of the Invention

The present invention relates to a housing module for use in a rack cabinet having an application in the electrical, computer and telecommunications equipment housing unit industry, and more specifically in the telecommunications field as a TV headend.

### Background of the Invention

Rack cabinets are units having standard dimensions for storing electrical, computer and telecommunications equipment.

Different shelves can be located and fixed in these cabinets by means of fixing same in two support columns located inside the cabinets on each side, where the front face of each column comprises a plurality of holes the dimensions and separation of which are standard for the purpose of making the dimensions of the equipment to be housed in the rack cabinet, including TV headends, among others, universal.

To install such headends in a rack cabinet today, cage nuts are installed in holes of the rack to subsequently place the headend and screw it onto said nuts.

One of the problems in this installation mode is that the person installing the module must do manual and visual counting to determine the specific hole on the side in which one of said nuts has been installed for the purpose of installing the other side at the same height or level and so that the apparatus is level, usually according to a level that determines horizontality.

Another problem is that the person installing the module must have independent and separate elements, such as nuts and screws, as well as the corresponding tools for the correct placement thereof, with the time loss and complication it entails for the installation.

Finally, it is necessary to point out another problem resulting from the fact that, depending on the weight of the headend, more than one operator may be necessary for the installation thereof.

Document US 2011/0180316 discloses a housing module for use in a rack cabinet, the module comprises the features of the preamble of claim 1; the installation of the module does not require screws.

### Description of the Invention

The present invention relates to a housing module for use in a rack cabinet which allows overcoming the aforementioned installation problems.

The housing module proposed by the invention comprises two side elements separated from one another according to a standard distance in correspondence with the width of the rack cabinet.

Therefore, according to the invention each side element has a front edge with an outer bracing extending outwardly therefrom. The distance between the outer bracings is therefore greater than the distance between the side elements.

In turn, each outer bracing has a rear face with at least one securing tab prolonging therefrom. According to the invention, said at least two securing tabs are located at one and the same level and can be fitted into two holes located at one and the same level among the plurality of standard holes comprised in each of the support columns which the rack cabinet comprises on each side.

Therefore, once said at least two securing tabs are fitted into two holes of the rack cabinet located at one and the same level, the entire housing module is secured to the rack cabinet so that it is leveled in a manner parallel to said level, which preferably and in most cases is the horizontal, although there may be cases in which said level deliberately does not correspond with the horizontal to overcome any unevenness of the support surface.

A fast, simple and reliable way of coupling the module in a rack cabinet according to a specific level is thereby achieved.

The possibility of at least two securing tabs prolonging from the rear face of each outer bracing at a different level is contemplated. Obviously, each securing tab is located at the same level as the other securing tab located in the other side element. Securing of the module is therefore reinforced.

Likewise, according to a preferred embodiment the securing tabs having a downward L shape is contemplated, such that they can be introduced and remain fitted in the holes of the support columns of the rack cabinet by gravity. This makes insertion into the holes easier and complicates extraction thereof, for which purpose the module must be lifted, although the securing tabs can have any other shape.

The module can comprise at least one locking handle which is linked, with possibility of movement, to the inner face of a side element in which it is guided.

Said at least one locking handle can be moved between an unlocking position, in which it allows introducing and extracting the securing tabs into/from the holes of the rack cabinet, and a locking position, in which at least one locking tab extending from a rear face of said at least one locking handle goes through a hole located in the outer bracing right above a securing tab, preventing extraction of said securing tab once it is introduced into the corresponding hole in the rack; considering the quadrangular dimensions of the hole and securing tab, the interposition of the locking tab in the hole when the tab is inserted therein prevents extraction thereof. Obviously, maintaining the locking and unlocking positions is contemplated by means of the locking handle being lightly clamped to the side element.

According to a preferred embodiment, the module comprises a level that is visible during installation of the module which allows the person installing said module to assure parallel placement thereof according to a specific level.

The invention allows overcoming all the problems of the state of the art by means of including the mentioned tabs and locking handles. In a first installation step of coupling the headend to the rack, the locking handles are pulled out, thereby unlocking them, the headend secured by gravity by means of the tabs is placed, for which purpose a level is included to assure that it is correctly installed, and the handles are pushed to the locking position, for which purpose the handles have the locking tab which is a projection filling the empty space in the hole of the rack of one of the securing tabs, although they can be in any number of them, it is sufficient and more economical if it is done in a single securing tab, therefore preventing the headend from being taken out of the rack.

### Description of the Drawings

To complement the following description and for the purpose of aiding to better understand the features of the invention according to a preferred practical embodiment thereof, a set of drawings is attached as an integral part of said description in which the following has been depicted with an illustrative and nonlimiting character:

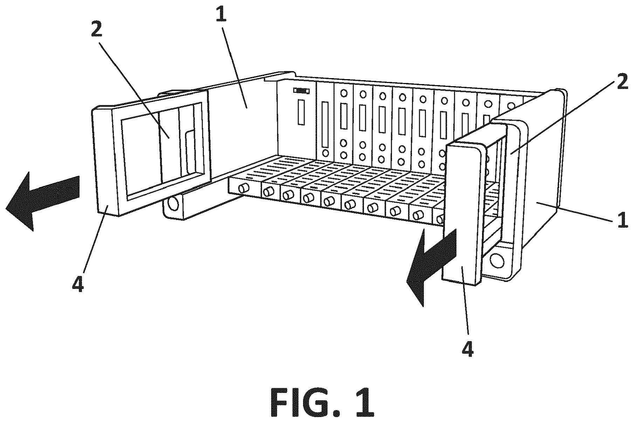

Figure 1 shows a schematic view of the unlocking position of a preferred embodiment of the module of the invention.
Figure 2 shows a view like that of Figure 1 of the coupling of the module to the rack, being able to see a detail of one of the securing tabs.

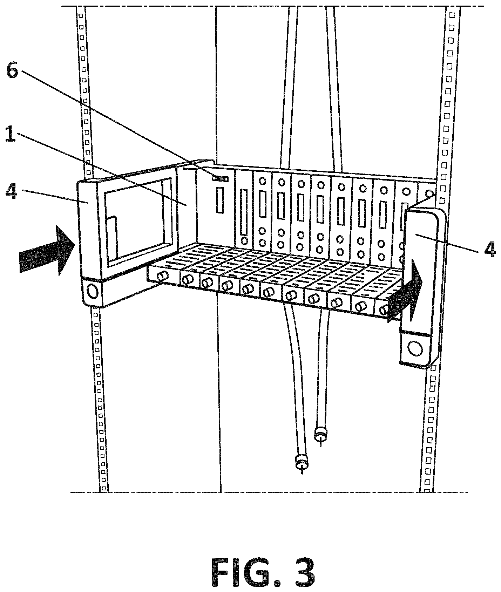

Figure 3 shows a view like that of Figures 1 and 2 of the locking position of the module in the rack.
Figure 4 shows a perspective view of a preferred embodiment of the module as a TV headend in the unlocking position.
Figure 5 shows a detail of the unlocking position in which the arrangement of the locking tab on the rear face of the locking handle is seen.
Figure 6 shows a detail like that of Figure 5 in the locking position.

### Preferred Embodiment of the Invention

In view of the described drawings, it can be seen how in one of the possible embodiments of the invention the module proposed by the invention comprises two side elements (1) separated from one another according to a standard distance in correspondence with the width of a rack cabinet.

Each side element (1) has a front edge with an outer bracing (2) extending outwardly therefrom. In turn, each outer bracing (2) has a rear face with four securing tabs (3) prolonging therefrom. According to the invention, each pair of securing tabs (3) located in different side elements (1) are located at one and the same level and can be fitted into two holes located at one and the same level among the plurality of standard holes comprised in each of the support columns which the rack cabinet comprises.

Therefore, once the securing tabs (3) are fitted into the holes of the rack cabinet the entire housing module is secured to the rack cabinet so that it is leveled in a manner parallel to said level, which is preferably the horizontal.

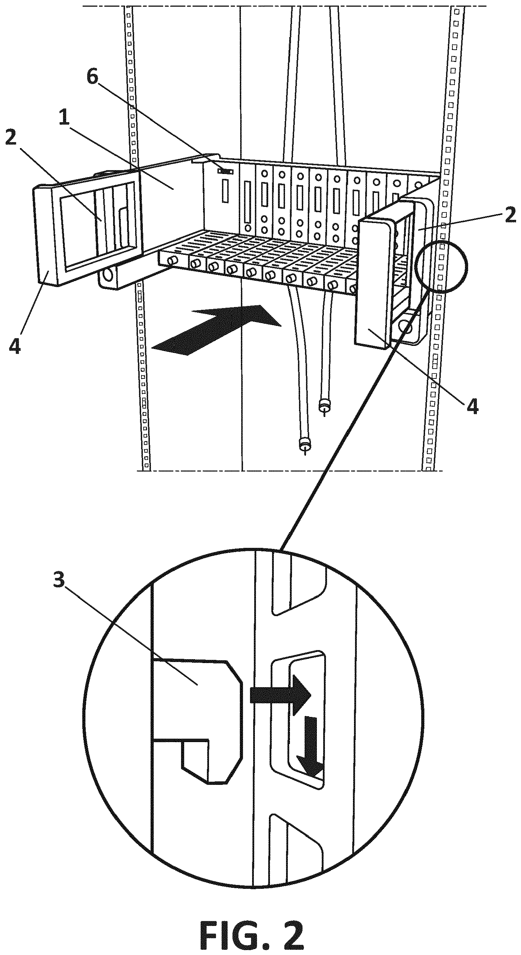

As seen in the detail of Figure 2, the securing tabs (3) have a downward L shape, such that they can be introduced and remain fitted in the holes of the support columns of the rack cabinet by gravity. The holes of the rack have relative dimensions with respect to the securing tabs (3) such as those depicted in said detail of Figure 2. It thereby makes insertion into the holes easier and complicates extraction thereof, for which purpose the module must be lifted, although the securing tabs can have any other shape.

The module comprises two locking handle (4), each of which is linked, with possibility of movement, to the inner face of a side element (1).

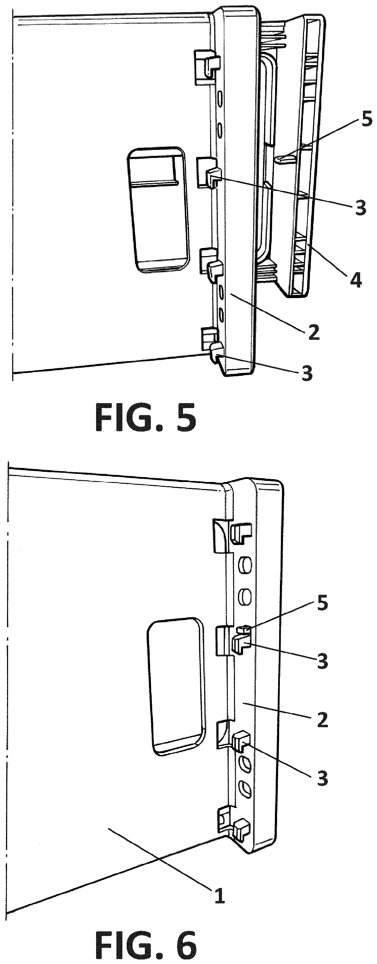

Therefore, each locking handle (4) can be moved between an unlocking position, in which it allows introducing and extracting the securing tabs (3) into/from the holes of the rack cabinet, and a locking position, in which a locking tab (5) extending from a rear face of each locking handle (4) goes through a hole located in the outer bracing (2) right above one of the securing tabs (3), preventing extraction of said securing tab (3) once it is introduced into the corresponding hole in the rack, as inferred from the depiction of the unlocking and locking positions of Figures 5 and 6, respectively.

It can be seen in Figure 2 that a preferred embodiment of the module comprises a level (6) that is visible during installation of the module, located on the inner face of the back portion, for example, allowing the person installing the module to assure parallel placement thereof according to a specific level, i.e., the horizontal placement thereof.

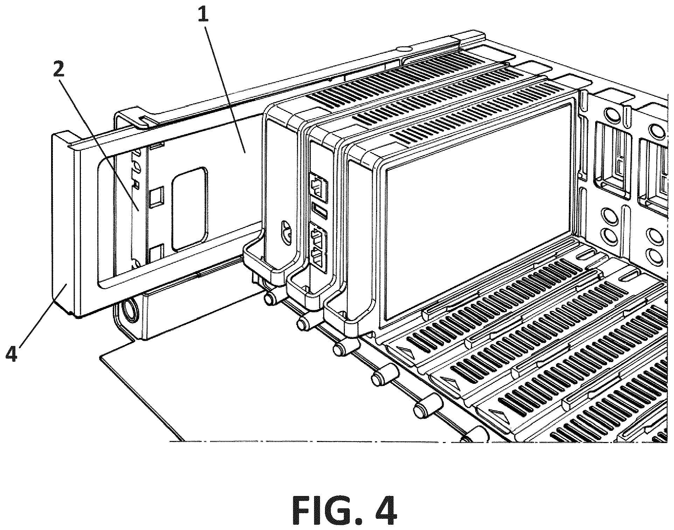

As depicted in the preferred embodiment of Figure 4, the housing module is a TV headend.

In view of this description and set of drawings, the person skilled in the art will understand that the embodiments of the invention that have been described can be combined in many ways within the object of the invention. The invention has been described according to several preferred embodiments thereof, but for the person skilled in the art it will be obvious that multiple variations can be introduced in said preferred embodiments without exceeding the object of the claimed invention.

## Claims

1. Housing module for use in a rack cabinet, where said module comprises two side elements (1) separated from one another according to a standard distance in correspondence with the width of the rack cabinet, wherein each side element (1) has a front edge with an outer bracing (2) extending therefrom, such that the distance between the outer bracings (2) is greater than the distance between the side elements (1); where each outer bracing (2) has a rear face with at least one securing tab (3) prolonging therefrom, such that said at least two securing tabs (3) are located at one and the same level and can be fitted into two holes located at one and the same level among the plurality of standard holes comprised in each of the support columns which the rack cabinet comprises on each side, such that once said at least two securing tabs (3) are fitted into two holes of the rack cabinet located at one and the same level, the housing module is secured to the rack cabinet so that it is leveled in a manner parallel to said level, the securing tabs (3) having a downward L shape, such that they can be introduced and remain fitted in the holes of the support columns of the rack cabinet by gravity,
**characterized in that**
the module further comprises at least one locking handle (4) which is linked, with possibility of movement, to the inner face of a side element (1), where said at least one locking handle (4) can be moved between an unlocking position, in which it allows introducing and extracting the securing tabs (3) into/from the holes of the rack cabinet, and a locking position, in which at least one locking tab (5) extending from a rear face of said at least one locking handle (4) goes through a hole located in the outer bracing (2) right above a securing tab (3), preventing extraction of said securing tab (3) once it is introduced into the corresponding hole in the rack.

2. Module according to claim 1, wherein at least two securing tabs (3) prolong from the rear face of each outer bracing (2) at a different level, where each securing tab (3) is located at the same level as the other securing tab (3) located in the other side element (1).

3. Module according to any of the preceding claims comprising a locking handle (4) in each side element (1).

4. Module according to any of the preceding claims comprising a level (6) that is visible during installation of the module which allows the person installing the module to assure parallel placement thereof according to a specific level.

5. Module according to any of the preceding claims, wherein the housing module is a TV headend.

## Patentansprüche

1. Gehäusemodul zur Verwendung in einem Gestellschrank, wobei das Modul zwei Seitenelemente (1) umfasst, die gemäß einem Standardabstand entsprechend der Breite des Gestellschranks voneinander getrennt sind, wobei jedes Seitenelement (1) eine Vorderkante mit einer ausgehend von dieser sich erstreckenden äußeren Aussteifung (2) aufweist, so dass der Abstand zwischen den äußeren Aussteifungen (2) größer als der Abstand zwischen den Seitenelementen (1) ist; wobei jede äußere Aussteifung (2) eine Rückseite mit mindestens einer ausgehend von dieser sich erstreckenden Halteklammer (3) aufweist, so dass die mindestens zwei Halteklammern (3) in einer und derselben Ebene angeordnet sind und in zwei Löchern, die in einer und derselben Ebene unter der Mehrzahl von Standardlöchern, die jede der Stützsäulen aufweist, die der Gestellschrank auf jeder Seite umfasst, eingesetzt werden können, so dass, sobald die mindestens zwei Halteklammern (3) in zwei Löcher des Gestellschranks, die in einer und derselben Ebene angeordnet sind, eingesetzt worden sind, das Gehäusemodul an dem Gestellschrank derart befestigt ist, dass es in einer Weise parallel zu der Ebene geebnet ist, wobei die Halteklammern (3) eine nach unten weisende L-Form derart aufweisen, dass sie in die Löcher der Stützsäulen des Gestellschranks eingesetzt werden können und in den Löchern durch Schwerkraft eingesetzt verbleiben können,
**dadurch gekennzeichnet, dass**
das Modul ferner mindestens einen Verriegelungsgriff (4) umfasst, welcher, mit der Möglichkeit für Bewegung, mit der Innenseite eines Seitenelements (1) verbunden ist, wobei der mindestens eine Verriegelungsgriff (4) zwischen einer Entriegelungsstellung, in welcher ermöglicht wird, dass die Halteklammern (3) in die Löcher des Gestellschranks eingesetzt werden können bzw. aus den Löchern des Gestellschranks herausgezogen werden können, und einer Verriegelungsstellung, in welcher mindestens eine Verriegelungslasche (5), die von der Rückseite des mindestens einen Verriegelungsgriffs (4) erstreckt, durch ein Loch geführt ist, das in der äußeren Aussteifung (2) rechts oberhalb einer Verriegelungslasche (3) angeordnet ist, wodurch ein Herausziehen der Verriegelungslasche (3) vermieden wird, sobald sie in das entsprechende Loch in dem Gestell eingesetzt worden ist.

2. Modul nach Anspruch 1, wobei sich mindestens zwei Verriegelungslaschen (3) von der Rückseite von jeder äußeren Aussteifung (2) in einer unterschiedlichen Ebene erstrecken, wobei jede Verriegelungslasche (3) in der gleichen Ebene angeordnet ist wie die andere Verriegelungslasche (3), die in dem anderen Seitenelement (1) angeordnet ist.

3. Modul nach einem der vorgehenden Ansprüche umfassend einen in jedem Seitenelement (1) angeordneten Verriegelungsgriff (4).

4. Modul nach einem der vorgehenden Ansprüche umfassend eine Ebene (6), die während der Installation des Moduls sichtbar ist, wodurch der das Modul installierenden Person ermöglicht wird, eine parallele Anordnung davon entsprechend einer spezifischen Ebene zu gewährleisten.

5. Modul nach einem der vorgehenden Ansprüche, wobei das Gehäusemodul eine TV-Kopfstelle ist.

## Revendications

1. Module de boîtier destiné à être utilisé dans une baie, dans lequel ledit module comprend deux éléments latéraux (1) séparés l'un de l'autre selon une distance standard en correspondance avec la largeur de la baie, dans lequel chaque élément latéral (1) a un bord avant avec un renfort externe (2) s'étendant à partir de ce dernier, de sorte que la distance entre les renforts externes (2) est supérieure à la distance entre les éléments latéraux (1) ; où chaque renfort externe (2) a une face arrière avec au moins une languette de fixation (3) se prolongeant à partir de ce dernier, de sorte que lesdites au moins deux languettes de fixation (3) sont positionnées à un seul et même niveau et peuvent être montées dans deux trous positionnés à un seul et même niveau parmi la pluralité de trous standard compris dans chacune des colonnes de support que la baie comprend de chaque côté, de sorte qu'une fois que lesdites au moins deux languettes de fixation (3) sont montées dans deux trous de la baie, positionnés à un seul et même niveau, le module de boîtier est fixé à la baie, de sorte qu'il est mis à niveau parallèlement audit niveau, les languettes de fixation (3) ayant une forme de L descendant, de sorte qu'elles peuvent être introduites et rester montées dans les trous des colonnes de support de la baie, par gravité,
**caractérisé en ce que** :
le module comprend en outre au moins une poignée de verrouillage (4) qui est reliée, avec possibilité de déplacement, à la face interne d'un élément latéral (1), où ladite au moins une poignée de verrouillage (4) peut être déplacée entre une position de déverrouillage, dans laquelle elle permet l'introduction des languettes de fixation (3) dans les trous de la baie et l'extraction des celles-ci, et une position de verrouillage, dans laquelle au moins une languette de verrouillage (5) s'étendant à partir d'une face arrière de ladite au moins une poignée de verrouillage (4) passe par un trou positionné dans le renfort externe (2) juste au-dessus d'une languette de fixation (3), empêchant l'extraction de ladite languette de fixation (3) une fois qu'elle a été introduite dans le trou correspondant dans la baie.

2. Module selon la revendication 1, dans lequel au moins deux languettes de fixation (3) se prolongent à partir de la face arrière de chaque renfort externe (2) à un niveau différent, où chaque languette de fixation (3) est positionnée au même niveau que l'autre languette de fixation (3) positionnée dans l'autre élément latéral (1).

3. Module selon l'une quelconque des revendications précédentes, comprenant une poignée de verrouillage (4) dans chaque élément latéral (1).

4. Module selon l'une quelconque des revendications précédentes, comprenant un niveau (6) qui est visible pendant l'installation du module, qui permet à la personne qui installe le module de garantir sa mise en place parallèle selon un niveau spécifique.

5. Module selon l'une quelconque des revendications précédentes, dans lequel le module de boîtier est une tête de réseau de TV.
